Europäisches Patentamt

**European Patent Office**

Office européen des brevets

(19)

(11) Veröffentlichungsnummer: **0 038 578**
**B1**

(12) EUROPÄISCHE PATENTSCHRIFT

(45) Veröffentlichungstag der Patentschrift:
12.10.83

(51) Int. Cl.³: **H 05 K 5/04**

(21) Anmeldenummer: **81200146.9**

(22) Anmeldetag: **06.02.81**

(54) Steckbarer Modul für Hochfrequenzgeräte.

(30) Priorität: **22.04.80 CH 3083/80**

(43) Veröffentlichungstag der Anmeldung:
**28.10.81 Patentblatt 81/43**

(45) Bekanntmachung des Hinweises auf die Patenterteilung:
**12.10.83 Patentblatt 83/41**

(84) Benannte Vertragsstaaten:
**AT BE CH DE FR IT LI NL SE**

(56) Entgegenhaltungen:
**DE-A-1 791 204**
**DE-A-2 165 039**
**DE-A-2 430 641**
**DE-B-1 266 840**
**FR-A-2 302 633**
**US-A-3 270 252**

(73) Patentinhaber: **Autophon A.G., Ziegelmattstrasse 1-15,
CH-4500 Solothurn 3 (CH)**

(72) Erfinder: **Frech, Hans, Lommiswilerstrasse 28,
CH-4515 Oberdorf (Kanton Solothurn) (CH)**
Erfinder: **Kaufmann, Alfred, Weidengasse 29,
CH-4052 Basel (Kanton Basel-Stadt) (CH)**
Erfinder: **Kummer, Hans, Dr. Rud. Probst-Weg 3,
CH-4513 Langendorf (Kanton Solothurn) (CH)**
Erfinder: **Reber, Hansrudolf, Balmfluhstrasse 322,
CH-4524 Günsberg (Kanton Solothurn) (CH)**
Erfinder: **Vitelli, Stefan, Paradiesstrasse 138,
CH-4572 Ammannsegg(Kanton Solothurn) (CH)**

(74) Vertreter: **Bovard, Fritz Albert et al, Bovard & Cie.
Patentanwälte VSP-Rechtsanwälte Optingenstrasse 16,
CH-3000 Bern 25 (CH)**

## Steckbarer Modul für Hochfrequenzgeräte

Die vorliegende Erfindung betrifft einen steckbaren Modul für Hochfrequenzgeräte. Solche Moduln, welche aus einer in ein Metallgehäuse eingeschlossenen Dickfilm-Schaltung bestehen, sind bekannt. Das Gehäuse besteht dabei aus einem Grundteil mit einem darauf aufgeschweissten Deckel. An der Dickfilm-Schaltung sind Steckerstifte angelötet, von denen die einen mit dem Gehäuse leitend verbunden, die andern davon isoliert sind. Bei den bisher bekannten Ausführungen solcher Moduln ist das Metallgehäuse auf der Seite der Steckerstifte offen, und die Öffnung ist dort mit einer Kunststoffleiste, durch welche die Steckerstifte hindurchgeführt sind, abgeschlossen. Die Dickfilm-Schaltung ist im Gehäuse eingeklebt, und durch eine Vergussmasse ist eine weitere mechanische Verbindung zwischen Gehäuse, Dickfilm-Schaltung und Kunststoffleiste hergestellt.

Da in einem raumsparend aufgebauten, verschiedene solcher Moduln enthaltenden Gerät die Moduln sehr nahe beieinander angeordnet werden müssen und da auch innerhalb des Moduls die verschiedenen Bereiche nicht über das Gehäuse miteinander gekoppelt werden dürfen, ist es bei Moduln, welche in Frequenzbereichen zwischen 10 und 1000 MHz betrieben werden ausserordentlich wichtig, dass die Verbindungen zwischen dem Gehäuse und den an Masse gelegten Steckerstiften möglichst kurz sind und dass die Dickfilm-Schaltung möglichst weitgehend und allseitig vom Gehäuse umschlossen ist. Solche kurze Verbindungen waren bei den bisher bekannten Bauarten von Moduln nur schwer zu erreichen, und bei der erwähnten Konstruktion mit der Kunststoffleiste ist das Gehäuse nicht allseitig geschlossen.

Die vorliegende Erfindung löst nun die Aufgabe, in Moduln der beschriebenen Art das Gehäuse mit den an Masse führenden Steckerstiften auf kürzestem Wege zu verbinden und die Verwendung eines allseitig geschlossenen Metallgehäuses zu ermöglichen. Sie betrifft einen Modul mit den im Oberbegriff des Patentanspruchs 1 beschriebenen Merkmalen, welcher dadurch gekennzeichnet ist, dass der Grundteil des Gehäuses wannenförmig ist, dass an einer der Seitenwände des wannenförmigen Teils Öffnungen angebracht sind, deren Durchmesser die Dicke der Steckerstifte übersteigt und durch welche die Steckerstifte aus dem Gehäuse herausgeführt sind und dass die Stifte in bezug auf die Öffnungen mindestens angenähert zentral angeordnet sind. Ein weiteres Kennzeichen dieses Moduls besteht darin, dass die mit dem Gehäuse verbundenen Stifte je im Bereich der Durchführung durch die zugehörige Öffnung eine kragenförmige, der Grösse der Öffnung entsprechende Verdickung aufweisen, welche je mit einem losen Sitz in die Öffnung hineinpasst und welche mit dem Gehäuse durch mindestens eine mittels Laser angebrachte Schweiss-Stelle verbunden ist. Mit einer bevorzugten Ausführungsform der Erfindung ist es möglich, für verschiedene Varianten von Ausführungen gleiche Bestandteile zu verwenden, wodurch eine Vereinfachung der Fertigung und der Lagerhaltung und damit eine Verbilligung möglich ist.

Die Erfindung wird nun anhand eines Ausführungsbeispiels erklärt. Dieses Beispiel betrifft ein Modul mit verschiedenen Arten von Steckerstiften.

Die Figur 1 zeigt von diesem Modul eine Ansicht von der Seite, und die Figur 2 zeigt eine Ansicht von oben, wobei ein Teil des Gehäuses aufgeschnitten ist.

Die Figuren 3 bis 7 zeigen je einen Teil eines Schnittes durch den in den Figuren und 2 dargestellten Modul, wobei in jedem Schnitt eine besondere Art von Steckerstift gezeigt ist.

Die Figur 8 zeigt einen den Figuren 3 bis 7 entsprechenden Teil eines Schnittes an einer Stelle, an welcher das Anbringen eines Stiftes möglich wäre, wo aber kein solcher Stift angeordnet wurde.

Die Figur 9 zeigt von einem Modul einen Teil der Draufsicht auf die Seite mit den Steckerstiften.

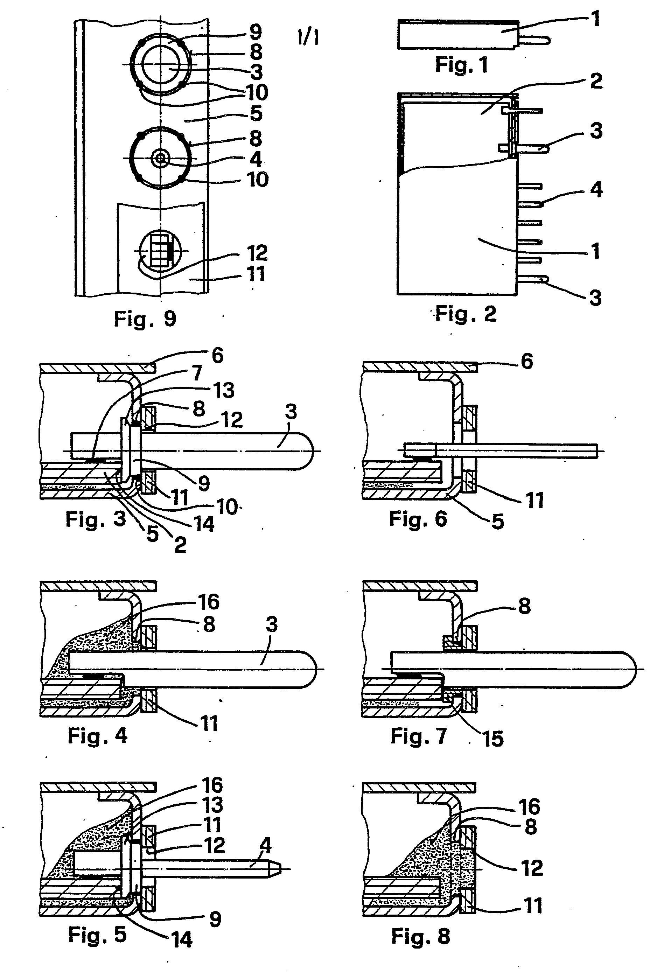

Der in den Figuren 1 und 2 dargestellte Modul weist ein Metallgehäuse 1 mit einem aufgelöteten, in der Figur 2 zum Teil weggeschnittenen Deckel auf. Im Innern des Gehäuses ist eine Dickfilm-Schaltung 2 angebracht, welche lediglich mit ihren Umrissen dargestellt ist und welche die Wände des Gehäuses nirgends berührt. Die Länge des Gehäuses beträgt ungefähr 3 cm. Am Rande der Dickfilm-Schaltung sind Steckerstifte aufgelötet. Von diesen Stiften sind die Stifte 3, welche in der Folge als grosse Stifte bezeichnet werden, länger und dicker als die kleinen Stifte 4. Mit der Anordnung von verschiedenen Arten von Stiften kann eine beschränkte Zahl von Steckerbildern erzeugt werden, wodurch in einem beschränkten Rahmen eine Unverwechselbarkeit von verschiedenen Moduln in bezug auf das Einstecken in entsprechend angeordnete Buchsen erreichbar ist.

Die Stifte unterscheiden sich ausser in ihrer Grösse noch insofern als die einen davon als Masseanschlüsse dienen und mit dem Gehäuse verbunden sind, während dies bei den andern nicht zutrifft. Es sind somit insgesamt vier Typen von Steckerstiften vorhanden, und in jeder der Figuren 3 bis 6 welche je den vergrösserten Schnitt durch einen Teil des Moduls darstellen, ist ein von den drei andern verschiedener Typ eines Stiftes dargestellt.

Die Figuren zeigen ausser den später beschriebenen Stiften ein aus einem Grundteil 5 und einem aufgelöteteten Deckel 6 bestehendes Gehäuse. Das Grundteil ist wannenfömig. Im Innern des Gehäuses befindet sich die auf den Boden des Unterteils aufgeklebte Dickfilm-Schaltung 2 auf welche an der Lötstelle 7 ein Stift aufgelötet ist. Die Stifte durchdringen das Gehäuse an Öffnungen 8, welche an einer seiner Schmalseiten angebracht sind. Diese Öffnungen haben untereinander den gleichen Abstand und sind gleich gross, so dass der gleiche Gehäusetyp für verschiedene Steckeranordnungen – unter Voraussetzung eines gleichen Abstandes der Stifte – verwendbar ist.

Der in Figur 3 dargestellte grosse Steckerstift ist zum Anschluss an Massepotential bestimmt. Er weist im Bereich der Öffnung 8 eine kragenförmige Verdickung 9 auf, welche mit einem losen Sitz in die Öffnung 8 hineinpasst. Wie aus der an oberster Stelle in der Figur 9 gezeigten Draufsicht auf den Stift 3 und die Schmalseite des Gehäuses ersichtlich ist, ist die kragenförmige Verdickung 9 mit vier Laser-Schweissstellen 10 mit dem Gehäuse verbunden. Diese kürzestmögliche Verbindung zwischen Gehäuse und Stift wirkt sich bei den im Modul verarbeiteten sehr hohen Frequenzen ausserordentlich günstig aus.

Um das Grundteil 5 von den Leiterbahnen der nicht dargestellten Leiterplatte, in welche der Modul einsteckbar ist, zu isolieren, ist auf die Schmalseite des Gehäuses eine Lochleiste 11 aus Isoliermaterial aufgeklebt. Diese Lochleiste, welche im obern Teil der Figur 9 weggeschnitten ist, weist Öffnungen 12 auf, deren Durchmesser der Dicke der grossen Stifte 3 und deren Abstand dem Abstand der Öffnungen 8 im Gehäuse angepasst ist. Unter diesen Voraussetzungen ist nur ein einziger Typ solcher Leisten für die verschiedenen Steckerbilder notwendig.

Die Figur 5 zeigt einen der kleinen Stifte 4, welcher ebenfalls zum Anschluss von Masse an die Dickfilm-Schaltung und das Gehäuse bestimmt ist. Die kragenförmige Verdickung 9 des Stiftes entspricht genau derjenigen an dem in Figur 3 dargestellten Stift. Der in Figur 5 gezeigte Stift ist in der Figur 9 in der Mitte dargestellt, wo auch die Laser-Schweissstellen 10 ersichtlich sind. In Figur 5 ist im Gegensatz zu Figur 3 zwischen dem Stift und dem Rand der Öffnung 12 in der Lochleiste 11 ein Zwischenraum vorhanden.

Die in den Figuren 4, 6 und 7 dargestellten Stifte sind nicht zum Anschluss an Massepotential bestimmt und weisen daher keine kragenförmige Verdickung auf. Die betreffenden Stifte berühren dort beim Durchtritt durch die Öffnung 8 das Gehäuse nicht. Während die Stifte in den Figuren 3, 4, 5 und 7 einen runden Querschnitt mit einem abgeflachten, dem Verlöten mit der Dickfilm-Schaltung dienenden Teil aufweisen, ist für den in der Figur 6 dargestellten Stift eine flache, wesentlich weniger aufwendige Ausführung möglich. Dies ist auch in der untersten Darstellung von Figur 9 ersichtlich, welche der Figur 6 entspricht. Im Gegensatz zu den beiden obern Darstellungen ist dort die Lochleiste 11 nicht weggeschnitten.

Die zum Anschluss an Massepotential bestimmten Stifte in den Figuren 3 und 5 weisen ausser der Verdickung 9 noch eine weitere kragenförmige Verdickung 13 mit einer vordern und einer hintern Schulter auf, deren Durchmesser den Durchmesser der Öffnungen 8 im Gehäuse übertrifft. Der betreffende Stift ist dabei derart an der Dickfilm-Schaltung 2 angelötet, dass die Vorderkante der Schaltung an der hintern Schulter 14 der Verdickung 13 ansteht, während die vordere Schulter die Innenwand des Gehäuse-Unterteils 5 berührt. Infolgedessen sichert die Verdickung 13 die Einhaltung eines bestimmten Abstandes zwischen der Vorderkante der Dickfilm-Schaltung und der Gehäusewand, wodurch die Lage der Dickfilm-Schaltung innerhalb des Gehäuses festgelegt ist.

Es ist einleuchtend, dass für eine einwandfreie derartige Festlegung solche den Abstand sichernden Verdickungen an mindestens zwei voneinander möglichst weit entfernten Orten entlang der Vorderkante der Dickfilm-Schaltung notwendig sind. Sofern nun eine Dickfilm-Schaltung derart aufgebaut ist, dass nur ein einziger Masseanschluss vorhanden ist oder dass zwar mehrere vorhanden, jedoch nicht genügend weit voneinander entfernt angeordnet sind, ist es notwendig, an geeigneten Orten den notwendigen Abstand auf andere Art sicherzustellen. Wie in der Figur 7 dargestellt ist, geschieht dies im vorliegenden Ausführungsbeispiel durch das Anbringen mindestens einer Tülle 15 aus Isoliermaterial, welche über einen nicht mit Masse zu verbindenden Stift geschoben ist. Diese Tülle entspricht in ihrer äusseren Form den beiden in den Figuren 3 und 5 dargestellten Verdickungen 9 und 13, so dass somit ihr vorderer Teil in die entsprechende Öffnung 8 des Gehäuses passt und ihr hinterer kragenförmiger Teil einen Abstand zwischen der Dickfilm-Schaltung und der Gehäusewand sichert.

Die Figur 8 zeigt den Schnitt durch das Gehäuse an einem für das Anbringen eines Stiftes vorgesehenen Platz, an welchem jedoch kein Stift angelötet ist. Wie bereits erwähnt wurde, sind an allen Stellen des Gehäuses, an denen grundsätzlich Stifte angebracht werden könnten, Öffnungen 8 im Gehäuse und Öffnungen 12 in der Lochleiste 11 angebracht.

Zwecks Herstellung eines Moduls der beschriebenen Art werden vorerst unter Zuhilfenahme einer Lehre die Stifte 3 und 4 an die Dickfilm-Schaltung angelötet. Alsdann wird – sofern notwendig – auf einen oder zwei der Stifte eine Tülle 15 aufgeschoben und, nachdem ein Tropfen eines Klebstoffes auf den Boden des Gehäuses aufgebracht wurde, die Dickfilm-Schaltung mit den daran angelöteten Stiften in den Unterteil des Gehäuses eingelegt, indem vorerst die Stifte von innen her in die Öffnungen des Gehäuses eingeführt werden. Die Verdickungen 9 und gegebenenfalls die Vorderteile der Tüllen 15 werden in die entsprechenden Öffnungen des Gehäuses eingeschoben. Dank der Wirkung der Verdickungen 13 und gegebenenfalls der Hinterteile der Tüllen 15 kann die Lage der Dickfilm-Schaltung innerhalb des Gehäuses genau festgelegt werden.

Anschliessend an die zuletzt beschriebene Arbeitsphase wird bei allen für den Masseanschluss bestimmten, d.h. bei allen eine kragenförmige Verdickung 9 aufweisenden Stiften der Rand der letztgenannten Verdickung an mehreren Punkten 10 mittels Laser-Schweissung mit dem Rand der betreffenden Öffnung 8 im Gehäuse verbunden. Vier Schweissstellen, wie dies aus Figur 9 ersichtlich ist, haben sich als günstig erwiesen. Die Erfindung ist aber nicht an diese Zahl von Schweissstellen gebunden.

Nach dieser Verschweissung wird die Lochleiste 11 auf die Stifte aufgeschoben, und in das Gehäuse wird im Bereich der Durchführungen für die Stifte eine solche Menge einer klebrigen ersten Vergussmasse 16 eingefüllt, dass der Teil der Dickfilmschaltung, an welchem die Steckerstifte angelötet sind, von der Vergussmasse bedeckt ist, was in den figuren 4, 5 und 8 dargestellt ist. Stifte und Dickfilm-Schaltung sind infolgedessen mit dem Gehäuse fest vergossen, und bei den Stiften gemäss den Figuren 4 und 6 und beim Fehlen eines Stiftes gemäss Figur 8 kann die Vergussmasse durch die Öffnungen 8 des Gehäuses nach aussen dringen, wodurch die Lochleiste 11 mit dem Gehäuse verklebt wird. Viskosität und Oberflächenspannung der ersten Vergussmasse können derart gewählt werden, dass sie in den Anordnungen gemäss den Figuren 6 und 8 nicht über die Lochleiste 11 hinaus dringt.

Nachdem sich die Vergussmasse 16 verfestigt hat, wird das ganze wannenförmige Grundteil des Gehäuses und die darin eingeklebte Dickfilm-Schaltung mit einer in den Figuren nicht dargestellten durchsichtigen zweiten Vergussmasse vergossen, und anschliessend wird der Deckel 6 aufgeschweisst.

**Patentansprüche**

1. Steckbarer Modul für Hochfrequenzgeräte, mit einem aus einem Grundteil (5) und einem darauf aufgeschweissten Deckel (6) bestehenden Metallgehäuse, welches eine Dickfilm-Schaltung (2) mit angelöteten Steckerstiften (3, 4), von denen die einen mit dem Gehäuse leitend verbunden und die andern davon isoliert sind, umschliesst, dadurch gekennzeichnet, dass der Grundteil (5) des Gehäuses wannenförmig ist, dass an einer der Seitenwände des wannenförmigen Teils Öffnungen (8) angebracht sind, deren Durchmesser die Dicke der Steckerstifte (3, 4) übersteigt und durch welche die Steckerstifte aus dem Gehäuse (5) herausgeführt sind, dass die Stifte (3, 4) in bezug auf die Öffnungen (8) mindestens angenähert zentral angeordnet sind und dass die mit dem Gehäuse verbundenen Stifte (Fig. 3, Fig. 5) je im Bereich der Durchführung durch die zugehörige Öffnung (8) eine kragenförmige, der Grösse der Öffnung entsprechende Verdickung (9) aufweisen, welche je mit einem losen Sitz in die Öffnung (8) hineinpasst und welche mit dem Gehäuse (5) durch mindestens eine mittels Laser angebrachte Schweiss-Stelle (10) verbunden ist.

2. Steckbarer Modul nach dem Patentanspruch 1, in welchem Steckerstifte (3, 4) verschiedener Dicke verwendet sind, dadurch gekennzeichnet, dass die Durchmesser der genannten Öffnungen (8) gleich gross sind und sich nach dem dicksten der verwendeten Steckerstifte richten.

3. Modul nach dem Patentanspruch 1, dadurch gekennzeichnet, dass bei mindestens zwei Steckerstiften zwischen dem mit der die Öffnungen (8) aufweisenden Seitenwand des Gehäusegrundteils (5) parallel laufenden Rand der Dickfilm-Schaltung (2) und der genannten Seitenwand ein Kragen (13, 15) angebracht ist, dessen Durchmesser den Durchmesser der dem betreffenden Stift zugeordneten Öffnung (8) übersteigt und welcher den Rand der Dickfilm-Schaltung (2) in einem der Dicke des Kragens entsprechenden Mindestabstand von der genannten Seitenwand hält.

4. Modul nach dem Patentanspruch 3, dadurch gekennzeichnet, dass bei den mit einem Kragen versehenen, mit dem Gehäuse verbundenen Stiften der genannte Kragen als kragenförmige Verdickung (13) ausgebildet ist.

5. Modul nach dem Patentanspruch 3, dadurch gekennzeichnet, dass bei den mit einem Kragen versehenen, vom Gehäuse isolierten Stiften der Kragen an einer Isoliertülle (15) angebracht ist, welche den betreffenden Stift im Bereich der zugehörigen Öffnung (8) umschliesst.

6. Steckbarer Modul nach dem Patentanspruch 1, dadurch gekennzeichnet, dass aussen auf der die Öffnungen (8) aufweisenden Seitenwand des Gehäusegrundteils (5) eine mit Öffnungen (12) für den Durchtritt der Steckerstifte versehene Platte (11) aus Isoliermaterial aufgeklebt ist.

7. Steckbarer Modul nach dem Patentanspruch 6, in welchem Steckerstifte verschiedener Dicke verwendet sind, dadurch gekennzeichnet, dass die Durchmesser der genannten Öffnungen (2) gleich gross sind und sich nach dem dicksten der verwendeten Steckerstifte (3) richten.

**Revendications**

1. Module enfichable pour appareils à haute fréquence, comportant un boîtier métallique consistant en une partie de fond (5) et un couvercle (6) soudé sur celle-ci, ce boîtier entourant un circuit à film épais (2) auquel sont soudées des fiches de prise de courant (3, 4) dont certaines sont reliées de façon conductrice au boîtier et dont les autres sont isolées, caractérisé en ce que la partie de fond (5) du boîtier est en forme de cuvette, en ce que des ouvertures (8) sont ménagées dans une des parois latérales de la partie en forme de cuvette, le diamètre de ces ouvertures étant plus grand que l'épaisseur des fiches (3, 4), ces dernières étant amenées à l'extérieur du boîtier (5) à travers ces ouvertures, en ce que, relativement aux ouvertures (8), les fiches (3, 4) sont disposées au moins approximativement centralement, et en ce que les fiches reliées au boîtier (fig. 3, fig. 5) présentent chacune, dans le domaine de leur passage à travers l'ouverture (8) correspondante, une surépaisseur en forme de collerette (9) correspondant à la grandeur de l'ouverture, cette collerette étant adaptée sans serrage dans l'ouverture (8) et étant reliée au boîtier (5) par au moins un endroit de soudure (10) établi au moyen d'un laser.

2. Module enfichable selon la revendication 1, dans lequel les fiches de prise de courant (3, 4) sont de différentes épaisseurs, caractérisé en ce que les diamètres des dites ouvertures (8) ont la même grandeur et sont établis selon la plus épaisse des fiches utilisée.

3. Module selon la revendication 1, caractérisé en ce que, pour au moins deux fiches, un col (13, 15) est établi entre le bord du circuit à film épais (2) qui s'étend parallèlement à la paroi latérale de la partie de fond de boîtier (5) présentant les ouvertures (8) et cette dite paroi latérale, le diamètre de ce col étant supérieur au diamètre de l'ouverture dévolue à la fiche concernée, ce col maintenant le bord du circuit à film épais (2) à une distance minimum, correspondant à l'épaisseur du col, de la dite paroi latérale.

4. Module selon la revendication 3, caractérisé en ce que, pour les fiches munies d'un col et reliées avec le boîtier, le dit col est formé en tant qu'une surépaisseur (13) en forme de collerette.

5. Module selon la revendication 3, caractérisé en ce que pour les fiches munies d'un col mais isolées du boîtier, le col est rapporté sur une douille isolante (15) qui entoure la fiche concernée dans le domaine de l'ouverture (8) correspondante.

6. Module enfichable selon la revendication 1, caractérisé en ce qu'une plaque (11) de matériau isolant présentant des ouvertures (12) pour le passage des fiches de prise de courant, est collée à l'extérieur de la paroi latérale de la partie de fond (5) qui présente les ouvertures (8).

7. Module enfichable selon la revendication 6, dans lequel sont utilisées des fiches de prise de courant de différentes épaisseurs, caractérisé en ce que les diamètres des dites ouvertures (12) sont de même grandeur et sont établis en fonction des plus épaisses (3) des fiches utilisées.

**Claims**

1. Pluggable module for RF equipment having a metal housing consisting of a basic part (5) and a cover (6) welded thereto, which housing surrounds a thick-film circuit (2) having soldered-on plug pins (3, 4), some of which are conductively connected to the housing and others insulated therefrom, characterized in that the basic part (5) of the housing is tub-shaped, that on one of the sidewalls of the tub-shaped part there are openings (8) which have a diameter exceeding the thickness of the plug pins (3, 4) and through which the plug pins are led out of the housing (5), that the pins (3, 4) are at least substantially centrally disposed relative to the openings (8), and that the pins connected to the housing (Fig. 3, Fig. 5) each have in the region of the passage through the associated opening (8) a collar-shaped thickening (9) corresponding to the size of the opening, each of which thickenings fits with a loose fit into the opening (8) and is connected to the housing (5) by at least one weld (10) applied by means of a laser.

2. Pluggable module according to patent claim 1, in which plug pins (3, 4) of different thicknesses are used, characterized in that the diameters of the said openings (8) are equal and are determined by the thickest of the plug pins used.

3. Module according to patent claim 1, characterized in that in the case of at least two plug pins, a collar (13, 15) is mounted between the edge of the thick-film circuit (2) running parallel to the sidewall of the housing basic part (5) having the openings (8) and the said sidewall, the diameter of which collar exceeds the diameter of the opening (8) associated with the respective pin and which keeps the edge of the thick-film circuit (2) spaced from the said sidewall by a minimum distance corresponding to the thickness of the collar.

4. Module according to patent claim 3, characterized in that the case of the pins connected to the housing and provided with a collar, the said collar takes the form of a collar-shaped thickening (13).

5. Module according to patent claim 3, characterized in that in the case of the pins insulated from the housing and provided with a collar, the collar is attached to an insulating bush (15) which surrounds the respective pin in the region of the associated opening (8).

6. Pluggable module according to patent claim 1, characterized in that on the outside of the sidewall of the housing basic part (5) having the openings (8), a plate (11) of insulating material provided with openings (12) for the passage of the plug pins is adhesively affixed.

7. Pluggable module according to patent claim 6, in which plug pins of different thicknesses are used, characterized in that the diameters of the said openings (12) are equal and are determined by the thickest of the plug pins (3) used.

Fig. 9

1/1

Fig. 1

Fig. 2

Fig. 3

Fig. 6

Fig. 4

Fig. 7

Fig. 5

Fig. 8